(19) Europäisches Patentamt

European Patent Office

Office européen des brevets

(11) **EP 4 679 481 A1**

(12) **EUROPEAN PATENT APPLICATION**

(43) Date of publication:
**14.01.2026 Bulletin 2026/03**

(21) Application number: **25181941.3**

(22) Date of filing: **11.06.2025**

(51) International Patent Classification (IPC):
***H01J 37/05*** (2006.01)      ***H01J 37/26*** (2006.01)

(52) Cooperative Patent Classification (CPC):
**H01J 37/05; H01J 37/26;** H01J 2237/057;
H01J 2237/1538

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **09.07.2024 US 202418767485**

(71) Applicant: **FEI COMPANY
Hillsboro, OR 97124 (US)**

(72) Inventors:
• **HENSTRA, Alexander
  Utrecht (NL)**
• **MARSMANS, Daniel
  Utrecht (NL)**

(74) Representative: **Boult Wade Tennant LLP
Salisbury Square House
8 Salisbury Square
London EC4Y 8AP (GB)**

(54) **REDUCED BOERSCH EFFECT IN DISPERSIVE OPTICS**

(57)    The present disclosure describes systems, methods, algorithms, and non-transitory media storing computer-readable instructions for reducing the Boersch effect using dispersive optics, in various embodiments. A charged particle optical device can include a Wien filter disposed on a beam axis. The Wien filter can be configured to disperse particles of a beam of charged particles by energy in a dispersion plane. The dispersion plane can be parallel with the beam axis. The device an include an optical element disposed on the beam axis downstream of the Wien filter. The optical element can be configured to focus the beam of charged particles toward the beam axis. The device can also include a selector. The selector can be disposed on the beam axis at a position substantially corresponding to a third crossover plane downstream of the optical element.

EP 4 679 481 A1

**Description**

CROSS-REFERENCE TO RELATED APPLICATION

This application claims priority to US Non-Provisional Application 18/767,485, filed on July 9, 2024, the disclosure of which is incorporated herein by reference in its entirety.

TECHNICAL FIELD

Embodiments of the present disclosure are directed to charged particle optics systems, as well as algorithms and methods for their operation. In particular, some embodiments are directed toward techniques for attenuating the Boersch effect in dispersive optics.

BACKGROUND

Charged particle microscopy and microanalysis can include exposure of materials to a beam of electrons. Interaction between electrons and the sample generates different types of detectable signals that can be used for imaging and analysis. In transmission electron microscope (TEM) imaging and microanalysis, detailed information can be developed at the atomic scale, including images of the atomic and molecular structures of nanomaterials and crystalline materials.

TEM analysis of materials at progressively smaller length scales, such as those on the order of Angstroms to tens of Angstroms, includes loss spectroscopy techniques, such as electron energy loss spectroscopy (EELS). EELS depends in part on narrowly defined beam energy distributions, described in reference to the width of a zero-loss peak. Among other phenomena, the Boersch effect describes an increase in energy spread (e.g., a wider beam energy distribution) due at least in part to Coulomb interactions between the particles in a charged particle beam. As such, there is a need to develop components, systems, and methods for reducing the Boersch effect, for example, to improve energy resolution of a charged particle beam source.

BRIEF SUMMARY

Aspects of the present disclosure include systems, methods, algorithms, and non-transitory media storing computer-readable instructions for reducing the Boersch effect using dispersive optics, in various embodiments. In a first aspect, a charged particle optical device includes a Wien filter disposed on a beam axis. The Wien filter can be configured to disperse particles of a beam of charged particles by energy in a dispersion plane. The dispersion plane can be parallel with the beam axis. The device an include an optical element disposed on the beam axis downstream of the Wien filter. The optical element can be configured to focus the beam of charged particles toward the beam axis. The device can also include a selector. The selector can be disposed on the beam axis at a position substantially corresponding to a third crossover plane downstream of the optical element.

In some embodiments, the beam of charged particles defines a first crossover plane at a first point on the beam axis within the dispersive filter, and a second crossover plane downstream of the first crossover plane at a second point on the beam axis. The second point can substantially coincide with an exit from the dispersive filter. The Wien filter can include a double-focusing Wien filter.

In some embodiments, the Wien filter is characterized by an excitation parameter, $\varphi$. The position can correspond to a value of the excitation parameter $\varphi$ greater than about $3\pi/4$. The position can correspond to a value of the excitation parameter $\varphi$ from about $\pi$ to about $3\pi/2$. The position can correspond to a value of the excitation parameter $\varphi$ of about 4.3.

In some embodiments, the optical element is further configured to accelerate the particles of the beam of charged particles. The beam of charged particles can be characterized by a first beam current from about 5 nA to about 50 nA at an entrance to the dispersive filter and a second beam current greater than about 60 pA below the energy selector. Downstream of the selector, the beam of charged particles can be characterized by an energy distribution having a half-width at one hundredth of a maximum value from about 40 meV to about 200 meV. In some embodiments, the selector defines an aperture having a characteristic width from about 0.3 $\mu$m to about 1.3 $\mu$m.

In a second aspect, a charged particle beam system includes a charged particle source. The charged particle source can be configured to generate a beam of charged particles substantially aligned with a beam axis. The system can include a monochromator of the first aspect in one or more embodiments. The monochromator can include a Wien filter disposed on the beam axis. The Wien filter can be configured to disperse particles of the beam of charged particles by energy in a dispersion plane parallel with the beam axis. The monochromator can include an optical element disposed on the beam axis downstream of the Wien filter. The optical element can be configured to focus the beam of charged particles toward the beam axis. Monochromator can include a selector, disposed on the beam axis at a position substantially corresponding to a third crossover plane downstream of the optical element. The system can also include a condenser lens, disposed on the beam axis downstream of the monochromator and configured to focus particles of the beam of charged particles toward the beam axis.

In some embodiments, the system includes input optics. The input optics can be configured to receive the beam of charged particles from the charged particle source. The input optics can also be configured to focus the beam of charged particles toward the beam axis. The input optics can be disposed on the beam axis between the charged particle source and the monochromator.

In a third aspect, a process for reducing the Boersch effect using dispersive optics includes generating a beam of charged particles. The process can include dispersing the charged particles of the beam of charged particles. The process can also include narrowing the energy distribution of the beam. In some embodiments, dispersing the beam of charged particles can include modifying one or more parameters of a dispersing element of the preceding aspects in one or more embodiments. The one or more parameters of the dispersing element can include an electric field in a Wien filter, a magnetic field of the Wien filter, and/or one or more parameters of an accelerator forming a part of a monochromator. Modifying the one or more parameters can include configuring the Wien filter to operate in accordance with an excitation parameter, $\phi$, that has a value from about $0.5\pi$ to about $1.5\pi$. in some embodiments, the excitation parameter is about 4.3.

The process of the third aspect, in one or more embodiments, can be implemented automatically (e.g., as computer-implemented method), pseudo-automatically (e.g., with human initiation and/or limited input from a user), and/or manually (e.g., with direction from a user of the systems and devices of the preceding aspects). To that end, the process of the third aspect can be at least partially stored as machine-readable instructions in one or more machine-readable storage media. The execution of such instructions by a machine can cause systems and/or devices of the present disclosure to perform one or more operations of the third aspect.

The terms and expressions which have been employed are used as terms of description and not of limitation, and there is no intention in the use of such terms and expressions of excluding any equivalents of the features shown and described or portions thereof, but it is recognized that various modifications are possible within the scope of the claimed subject matter. Thus, it should be understood that although the present claimed subject matter has been specifically disclosed by embodiments and optional features, modification and variation of the concepts herein disclosed can be resorted to by those skilled in the art, and that such modifications and variations are considered to be within the scope of this disclosure as defined by the appended claims. For example, the preceding aspects and various embodiments can be combined with one or more other aspects and/or embodiments of the same or other aspects.

BRIEF DESCRIPTION OF THE SEVERAL VIEWS OF THE DRAWINGS

The foregoing aspects and many of the attendant advantages of the present disclosure will become more readily appreciated as the same become better understood by reference to the following detailed description, when taken in conjunction with the accompanying drawings.

FIG. 1 is a schematic diagram illustrating a transmission electron microscope (TEM) system, in accordance with some embodiments of the present disclosure.

FIG. 2 is a schematic diagram illustrating an example dispersing monochromated electron source configured for use in a transmission electron microscope (TEM) system, in accordance with the current art.

FIG. 3 is a schematic diagram illustrating an example dispersing monochromated electron source configured for use in a transmission electron microscope (TEM) system, in accordance with embodiments of the present disclosure.

FIG. 4 is a schematic diagram illustrating an example dispersing monochromated charged particle source configured for use in a transmission electron microscope (TEM) system, for which an excitation parameter, "$\phi$," does not attenuate the Boersch effect, in accordance with the current art.

FIG. 5 is a schematic diagram illustrating an example dispersing monochromated charged particle source for which an excitation parameter, "$\phi$," is used to reduce the influence of the Boersch effect, in accordance with embodiments of the present disclosure.

FIGs. 6A-6C are data plots illustrating analytical data for dispersion, Boersch effect, and normalized beam energy distribution (FWHM), respectively, for a dispersing monochromated electron source configured for use in a transmission electron microscope (TEM) system, in accordance with embodiments of the present disclosure.

FIG. 7 is a block flow diagram of an example process for generating a monochromated beam of charged particles, in accordance with some embodiments of the present disclosure.

FIGs. 8A-8B are example energy distribution graphs simulated for the electron source of FIG. 2, in accordance with the current art.

FIGs. 9A-9B are example energy distribution graphs simulated for the electron source of FIG. 3, in accordance with embodiments of the current disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

DETAILED DESCRIPTION

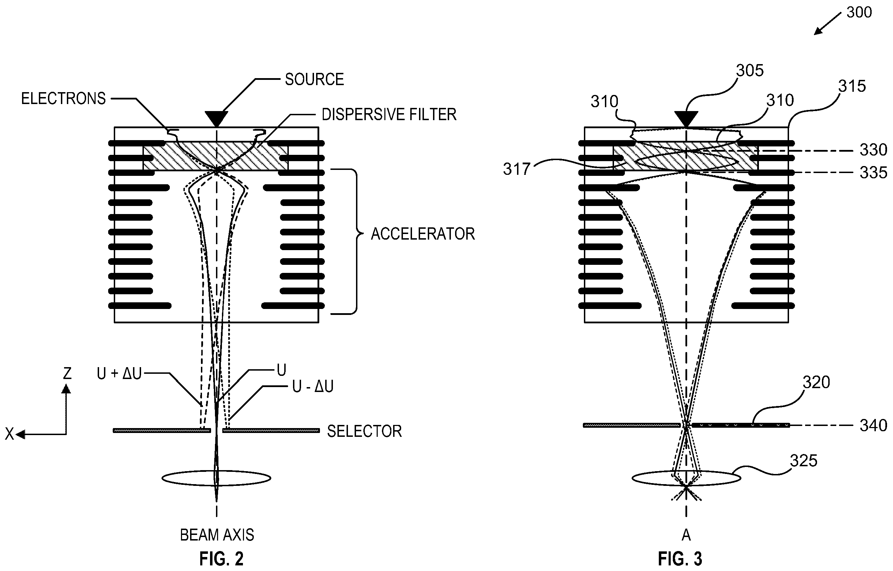

While illustrative embodiments have been illustrated and described, it will be appreciated that various changes can be made therein without departing from the spirit and scope of the disclosure. In the forthcoming paragraphs, embodiments of a charged particle microscope system, components, and methods for reducing the Boersch effect on beam energy distribution are provided. Embodiments of the present disclosure include a transmission electron microscope incorporating improved electron optical device(s). The improved electron source can include a monochromator configured to narrow an energy distribution of a monochromated beam of electrons having an energy distributed about a target energy. The monochromator can include a dispersing element disposed on a beam axis, the dispersing element being configured to disperse particles of a beam of charged particles by energy in a dispersion plane parallel with the beam axis. The electron optical device can include a selector disposed on the beam axis downstream of the monochromator at a position corresponding to a crossover plane on the beam axis. The crossover plane can correspond to a third crossover plane of the beam of charged particles downstream of an entrance to the monochromator on the beam axis. The cutoff can include a material that is opaque to electrons and can define an aperture that is substantially aligned with the beam axis, as described in more detail in reference to FIG. 3.

Embodiments of the present disclosure include systems, methods, algorithms, and non-transitory media storing computer-readable instructions for reducing the Boersch effect using dispersive optics. In an illustrative example, a method can include modifying one or more operating parameters of an energy-dispersive monochromator, such that the monochromator is characterized by an excitation parameter ("$\phi$") greater than about $3\pi/4$ (e.g., $\phi \approx 4.3$). Detailed description of the Boersch effect, the excitation parameter, and monochromator operation, follows.

Advantageously, the techniques of the present disclosure improve energy resolution of charged particle beam systems, allowing for more precise and accurate measurement of energy-dependent material properties, such as molecular bond information, inner-shell electron transitions, among others. In the example of energy loss spectroscopy, such as Electron Energy Loss Spectroscopy (EELS), inelastic scattering of electrons is measured by transmitting a beam of electrons through a sample. Inelastic scattering includes energy transfer between the electrons and the sample, which can be measured using a spectrometer configured to generate an energy loss spectrum for electrons transmitted through the sample. Through analysis of the energy loss spectrum, detailed material information (e.g., bonding arrangements, elemental composition, etc.) can be developed, including for samples of light elements that are otherwise challenging to analyze.

Electrons that pass through the sample without inelastic scattering (e.g., having lost little or no energy to the sample) form a zero-loss peak, or "ZLP," in the energy loss spectrum. The width of the zero-loss peak mainly reflects the energy distribution of the electron source. It is typically from about 0.2 eV to 2.0 eV, but can be narrower in a monochromated source. Information from valence electrons, such as plasmon resonance and interband transitions, can be derived from energy loss spectral information typically within about 50 eV of the zero loss peak. Information from inner-shell electrons, such as inner-shell ionization, can be derived from information typically beyond 100 eV from the zero loss peak. Further, imaging using the ZLP can improve spatial resolution of microscope images by selectively filtering scattered electrons.

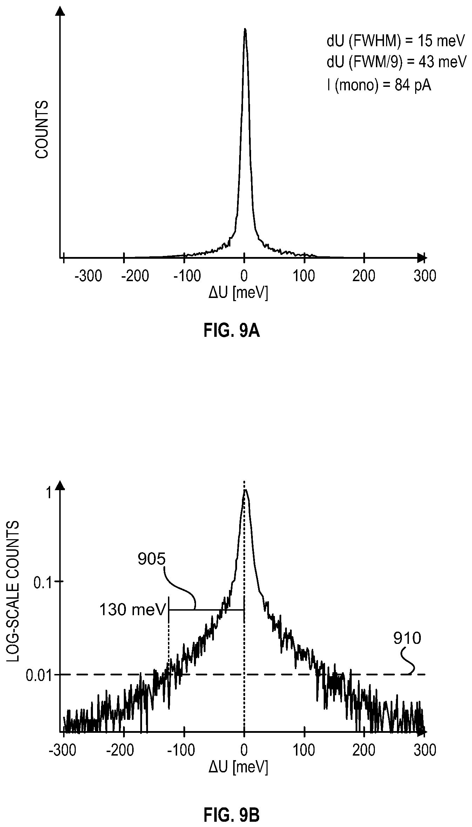

Valence electron information can be used in microanalysis of light elements, organic materials, and/or molecular samples for which detailed bonding information is sought. Such techniques are referred to as "vibrational EELS" that probe stretching, bending, scissoring, and other atomic and molecular bond transitions appearing in the energy loss spectrum within about 0.05 eV to about 1 eV of the zero loss peak. In this way, the width of the zero loss peak becomes a limiting factor for vibrational EELS, due at least in part to the background attributable to the zero loss peak. The width of the zero loss peak at the "1/100 limit," as described in more detail in reference to FIGs. 9A-10B, is a metric (among other metrics including full width at half maximum, or FWHM) used to describe the energy distribution of a monochromated electron source. The 1/100 limit corresponds to a value of the energy distribution of the beam of electrons that is 100 times smaller than a peak of the zero loss peak (e.g., at a loss of 0 eV).

Improvements to the width of a zero loss peak at the 1/100 limit can be based at least in part on attenuating the Boersch effect upstream of a selection plane. Narrowing the distribution of energies of charged particles emitted by a source can also improve performance (e.g., signal-to-noise and/or signal-to-background characteristics) of a charged particle spectroscopy system. In an illustrative example, via a combination of operating parameters of the source, the monochromator, and additional and/or alternative optical elements, charged particle optical devices of the present disclosure can be configured to output a beam of electrons having an energy deviation from a target energy of less than or equal to about 200 meV at the 1/100 limit.

Typical approaches for generating chromatic electron beams include using alpha-type monochromators or omega-type monochromators making use of curved electron beam paths and multiple electromagnetic prisms that are structurally and operationally complex. Such sources typically exhibit a width of greater than 80 meV at the 1/1000 limit (e.g., 86 meV for an $\alpha$-type monochromator, although the width can be smaller at the expense of probe current, with significant implications for EELS performance). In this context, the "width" of the zero loss peak refers to a half-width, measured from a center of the zero loss peak to the edge of the zero loss peak.

Such devices include complex arrangements of multiple charged particle optical elements and typically limit the beam current significantly. In this way, alpha-type or omega-type monochromator devices are designed as discrete modules (e.g., as retrofit modules) rather than a method of using in situ monochromator devices. There is a need, therefore, for monochromated charged particle sources, and techniques for their use, that are characterized by a zero loss peak half-width less than or equal to about 200 meV at the 1/100 limit. A quantitative explanation of the reduced Boersch effect in electron monochromators is given below. In particular, a mathematical derivation is presented of the equations for optimal reduction of the Boersch effect in a monochromator. As an initial example, the double focusing Wien filter is described, followed by a generalization to any dispersive charged particle optic device.

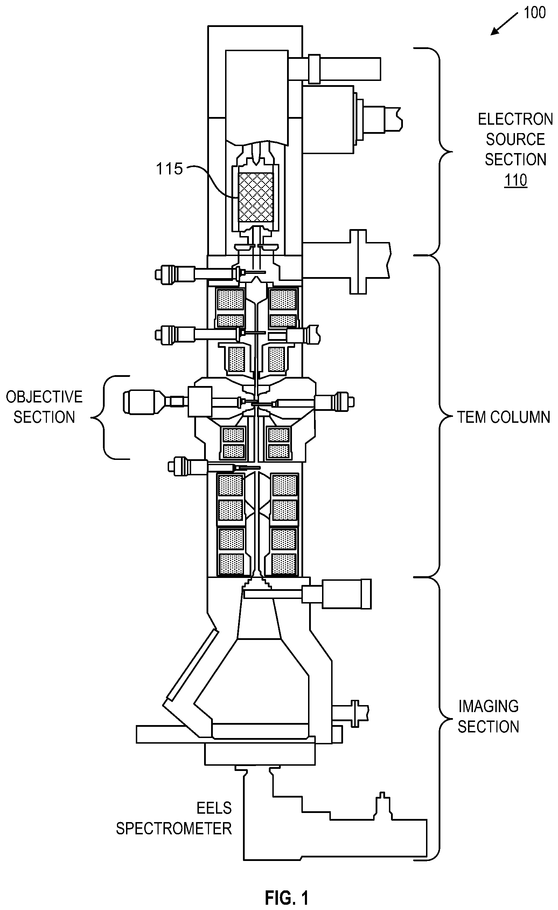

FIG. 1 is a schematic diagram illustrating a transmission electron microscope (TEM) system 100, in accordance with some embodiments of the present disclosure. In the following description, details of internal components and functions of the example TEM system 100 are omitted for simplicity and to focus description on embodiments of the present disclosure, as described in more detail in reference to FIGs. 3A-5, in contrast to typical systems described in FIG. 2A and FIG. 2B, and on techniques for augmenting the energy-resolution of monochromated beams of charged particles. The example TEM system 100 includes an electron source section 110, a TEM column including an objective section, and an imaging section. The present disclosure focuses on the electron gun section 110. In brief, the electron source section 110 includes electronics configured to energize an electron source, which can include a high-voltage field-emission source or other sources of emitted electrons, such that a beam of electrons is formed and conducted through a vacuum into the TEM column.

The TEM column includes components for beam forming, including electromagnetic lenses and electrostatic lenses and multiple apertures to control properties of the beam of electrons. TEM column components include condenser lenses, objective lenses, projector lenses, among others, as well as corresponding apertures. The imaging section includes one or more type of detector, sensor, screen, and/or optics configured to generate images, spectra, and other data for use in sample imaging and/or microanalysis. For example, the imaging section can include a scintillator screen, binoculars, transmission electron microscopy (TEM) detector(s) (e.g., pixelated electron detector, secondary electron detector, camera(s), and electron energy loss spectroscopy (EELS) spectrometers, among others.

As described in more detail in reference to FIGs. 2-5, TEM system 100 can include a charged particle optical device 115. The charged particle optical device 115 can include one or more monochromators, one or more electromagnetic lenses, one or more electrostatic lenses, one or more charged particle accelerator elements, one or more charged particle decelerator elements, and/or one or more apertures and/or slits that block and/or attenuate part of the beam of electrons (e.g., a foil defining a slit or aperture can be of suitable thickness such that some electrons can still penetrate the foil with a scatter angle and/or energy loss that don't disturb the resulting EELS spectrum). The configuration of constituent elements of the charged particle optical device 115 permits the example TEM system 100 to generate a monochromated beam of electrons characterized by an improved (e.g., relatively narrow) energy resolution, as measured at the 1/100 limit of the half maximum, as compared to existing systems that are more structurally and operationally complex. Further, the charged particle optical device 115 permits the example TEM system 100 to perform measurements with improved spatial resolution and/or energy resolution at a relatively higher current, above 10 pA, than what is currently available with comparable optical devices, without including more complex alpha-type monochromators.

FIG. 2 is a schematic diagram illustrating an example dispersing monochromated electron source configured for use in a transmission electron microscope (TEM) system, in accordance with the current art. A beam of electrons is generated by a source, such as a thermionic Schottky source, a field emission (FEG) source (e.g., a Schottky-FEG source or a cold FEG (CFEG) source), among others. The outer extents of the beam are shown to simplify the diagram and to focus description on the dispersing elements downstream of the source, but it is understood that electrons are also emitted between the lines illustrated (e.g., as shown in FIG. 3). In the dispersing monochromator shown, the beam of electrons is passed through a half-pi Wien filter configured to spatially disperse the electrons by energy in a dispersal plane parallel to the beam axis (e.g., the "x-z" plane). The half-pi Wien filter shown is an example of a "double focusing" Wien filter, which focuses in the XZ plane shown and the orthogonal YZ plane (not shown). The term "half-pi" in this context refers to an excitation parameter, $\phi$, that is discussed in more detail in the forthcoming paragraphs.

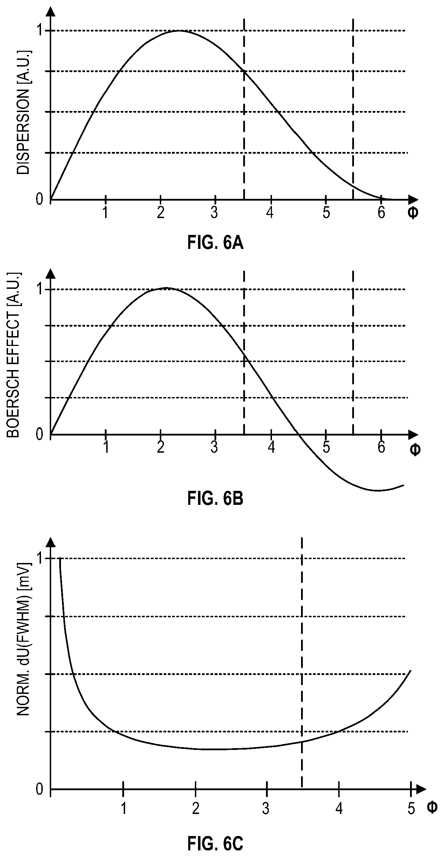

A selector can be disposed downstream of the monochromator to selectively block portions of the electron beam that have an energy different from a target energy ("U"). A selector can also be positioned at an exit of the Wien filter (e.g., plane 335 in FIG. 3). In the example source 200 of FIG. 2, the selector is disposed in a focal plane, where each individual energy is focused in the dispersive direction (X), and can also be focused in the non-dispersive direction (Y), at a point which depends on the electron energy. Due at least in part on the dispersion of the beam of electrons, the selector can selectively block electrons having an energy that deviates from the target energy ("U $\pm$ $\Delta$U") beyond a given tolerance,

where "$\Delta U$" refers to a deviation from the target energy. Placing the selector at a crossover plane on the beam axis where the electron beam is dispersed improves the energy resolution of the monochromator at the expense of a lower beam current after the selector. Reduced beam current is a disadvantage of the configuration of FIG. 2 with respect to vibrational EELS. The relative prominence of noise in the region of the zero loss peak where vibrational EELS information is found increases with decreasing beam current. Further, the Boersch effect increases with increasing beam current, as described in reference to FIG. 6A-6C, below. To that end, the Boersch effect can be understood to set an upper limit on beam current, above which the energy resolution of the monochromator is impaired, and the width of the selector aperture can depend at least in part on the desired energy resolution of the monochromator that is coupled with the beam current through the Boersch effect.

FIG. 3 is a schematic diagram illustrating an example dispersing monochromated electron source 300 configured for use in a transmission electron microscope (TEM) system, in accordance with embodiments of the present disclosure. The example source 300 includes a source 305, from which electrons 310 (also referred to as "primary electrons" or "beam electrons") emanate in a beam of electrons, a dispersing element 315, a selector 320, and an optical element 325, substantially aligned with a beam axis A. While FIG. 3 is described as a monochromated electron source, embodiments of the present disclosure are not limited to electron sources, but rather include other charged particle sources, such as ion sources.

The example source 300 can include at least some of the components of the source of FIG. 2, such as a dispersive filter and an accelerator. In contrast to the source of FIG. 2, however, the deviation from the target energy, "$\Delta U$," can be significantly reduced, based at least in part on a modification of an excitation parameter, "$\phi$," of the dispersive element 315, such that the electrons 310 of the beam exhibit different spatial and energetic properties (e.g., velocity) in the space between the source 305 and the selector 320, by which the Boersch effect can be reduced and the energy resolution of the example source 300 can be improved, relative to the source of FIG. 2.

In the example source 300, one or more operating parameters of the dispersive element 315, and/or the source 305 are modified such that the beam of electrons 310 exhibits a first crossover 330 and a second crossover 335 within the dispersive element 315, and a third crossover 340 plane substantially co-located with the selector 320. The selector 320 can define an aperture having a characteristic width from about 0.1 $\mu$m to about 5 $\mu$m, including fractions, interpolations, and sub-ranges thereof (e.g., from about 0.3 $\mu$m to about 1.3 $\mu$m). A width smaller than 0.3 $\mu$m can introduce aberrations in the beam due at least in part to interactions between the beam and the material of the selector 320, can limit the beam current excessively, and can damage the selector 320. A width larger than 1.3 $\mu$m can impair the effectiveness of the monochromator by permitting too large a range of energy in the charged particles that pass through the selector 320. Even so, larger aperture widths can be used for relatively modest monochromatization (e.g., $\Delta U$ at FWHM from about 0.3 eV to about 0.8 eV). For cases in which the selector 320 is positioned at an exit of the dispersive element 315, the width of the aperture (e.g., a slit width) can be from about 50 nm to about 1.0 $\mu$m, including subranges, fractions, and interpolations thereof.

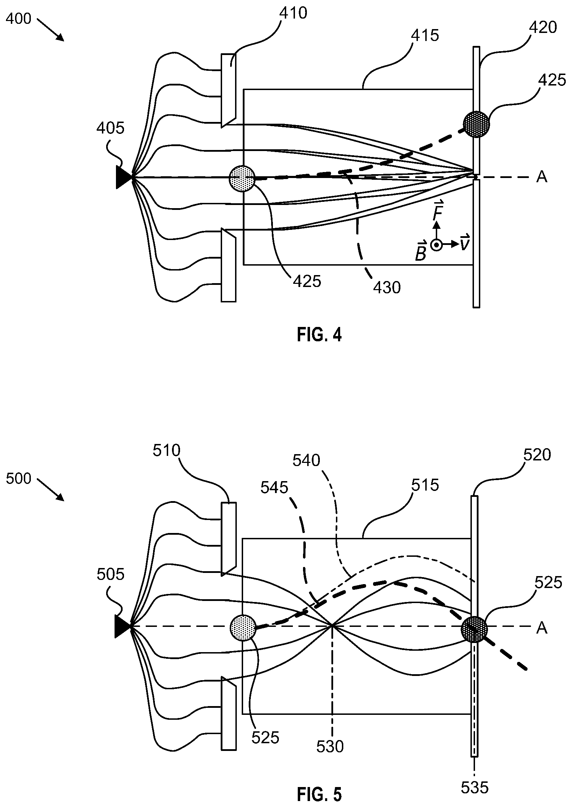

In some embodiments, the first crossover 330 and the second crossover 335 occur within a segment of the beam axis A that corresponds to a dispersive filter 317 (e.g., an electromagnetic prism or Wien filter). In some embodiments, the first crossover 330 occurs within the segment of the beam axis A that corresponds to the filter 317, and the second crossover 335 occurs outside the segment of the beam axis A corresponding to the filter 317 (e.g., within an accelerator segment). In some embodiments, the second crossover 335 can occur substantially at an exit of the filter 317, as described in more detail in reference to FIG. 5. The exit being a boundary opposite from the source 305.

While the illustration of FIG. 3 is not drawn to scale, the combination of operating parameters of the dispersive element 315 and/or the source 305 that together permit the example source 300 to reduce the influence of the Boersch effect on energy distribution (e.g., $\Delta U$), the beam of electrons 310 can exhibit increased divergence at the selector 320 and downstream of the optical element 325. To that end, TEM systems of the present disclosure can include column optics (e.g., TEM column section of FIG. 1) that are configured to condition, form, and shape the beam of electrons 310. These and other considerations are described in more detail in reference to FIGs. 4-6C, below.

FIG. 4 is a schematic diagram illustrating an example dispersing monochromated charged particle source 400 configured for use in a transmission electron microscope (TEM) system, for which an excitation parameter, "$\phi$," does not significantly attenuate the Boersch effect, in accordance with the current art. Example source 400 includes a charged particle source 405, a beam limiting aperture 410, a dispersing element 415, and a cutoff 420, disposed along a beam axis A at an exit of the dispersing element 415. The example source 400 is an embodiment of the example source 300 of FIG. 3, omitting the selector 320 of FIG. 3 to focus description on the influence of excitation parameter, $\phi$, on the operation of the dispersing element 415.

The dispersing element 415 can be or include a dispersive Wien filter or other electromagnetic element that imposes a magnetic field in a direction opposed to an electric field, the two being balanced such that a charged particle 425 experiences a deflection force (e.g., a Lorentz force, or F) that scales with the energy deviation ($\Delta U$) of the charged particle 425. One or more charged particle optical elements can be included between the source 405 and the source aperture 410, which are omitted for clarity of description.

In the case of a charged particle 425 for which the velocity is aligned with the beam axis A, and where the magnetic field and the electric field are normal to the beam axis A, the charged particle 425 will be deflected off-axis and into the cutoff 420 in cases where the charged particle 425 has an energy that deviates from a target energy (e.g., for which the Wien filter is calibrated). Where the charged particle 425 has an energy that is substantially equal to the target energy, the deflection force will be substantially zero, such that the charged particle passes through the cutoff 420 aperture and towards the optics of the TEM column.

The aperture 410 limits the beam current from the source 405. To that end, the example source 400 is configured to define a first beam crossover at the cutoff 420, such that charged particles that enter the dispersing element 415 at an off-axis position or trajectory converge toward the first beam crossover, at which the aperture of the cutoff 420 is disposed. Typically, the dispersing element 415 is configured to operate with an excitation parameter, $\phi$, of about $0.5\pi$. At values above $0.5\pi$, the dispersion typically increases with $\phi$, as described in more detail in reference to FIG. 6A.

FIG. 5 is a schematic diagram illustrating an example dispersing monochromated charged particle source 500 for which an excitation parameter, "$\phi$," is used to reduce the influence of the Boersch effect, in accordance with embodiments of the present disclosure. The example source 500 includes a source of charged particles 505, a beam limiting aperture 510, a dispersing element 515, and a cutoff 520. Example ray paths are illustrated to simplify comparison with the example source 400 of FIG. 4, where parallel rays of equivalent energy are illustrated to show the general behavior of the example source 500. The example source 500 is an embodiment of the example source 300 of FIG. 3, omitting the selector 320 of FIG. 3 to focus description on the influence of excitation parameter, $\phi$, on the operation of the dispersing element 515.

In example source 500, as with the example source 400 of FIG. 4, the dispersing element 515 can be or include a dispersive Wien filter or other electromagnetic element that imposes a magnetic field in a direction opposed to an electric field, the two being balanced such that a charged particle 525 experiences a deflection force (e.g., a Lorentz force, or F) that is proportional to the energy of the charged particle 525. One or more charged particle optical elements can be included between the source 505 and the source aperture 510, which are omitted for clarity of description.

In the case of a charged particle 525 for which the velocity is aligned with the beam axis A, and where the magnetic field and the electric field are normal to the beam axis A, the charged particle 525 will be deflected off-axis and into the cutoff 520 in cases where the charged particle 525 has an energy that deviates from a target energy (e.g., for which the Wien filter is calibrated). Where the charged particle 525 has an energy that is substantially equal to the target energy, the deflection force will be substantially zero, such that the charged particle passes through the cutoff 520 aperture and towards the optics of the TEM column.

In contrast to the example source 400 of FIG.4, one or more operating parameters of example source 500 is/are specified such that the excitation parameter, $\phi$, has a value greater than or equal to about $3\pi/4$. The resulting deflection force induces a sinusoidal trajectory for charged particles, as described in more detail in reference to FIGs. 6A-6C. The force applied to charged particles entering the dispersing element 515 at an off-axis position results in a first beam crossover 530 between the beam limiting aperture 510 and the cutoff 520. The charged particles 525 deviating from a given energy U by $\Delta$U that are unaffected by the Boersch effect are deflected such that the beam follows a trajectory 540 that defines a second crossover 535 at the cutoff 520. For a charged particle 525 that is affected by the Boersch effect, the deflection force imparts a trajectory 545 that intersects the cutoff 520, indicating that the charged particle 525 is blocked by the cutoff 520. A mathematical treatment of the Boersch effect is given in reference to FIGs. 6A-6C, below. Not shown in FIG. 5 is a third crossover (e.g., third crossover 340 of FIG. 3) that results from the focusing action of optics downstream of the Wien filter (e.g., the accelerator of FIG. 3). This third crossover can correspond to a position of a selector 340 external to the dispersing element 515, for example, downstream of the plane 535 (e.g., as an alternative to the cutoff 520).

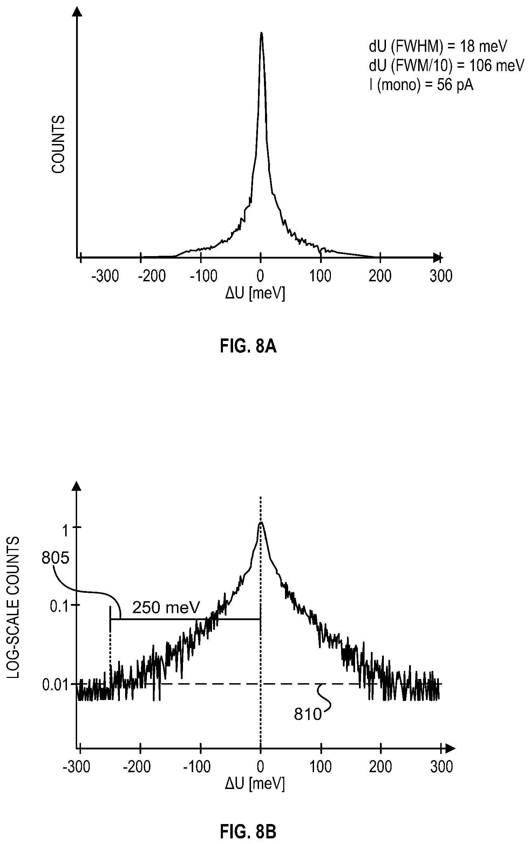

As described in more detail in reference to FIGs. 8-9B, the specification of an excitation parameter greater than or equal to about $3\pi/4$ reduces the influence of the Boersch effect, and improves the width of the energy distribution of the beam. In an energy dispersed beam, such improvement also corresponds to improved spatial resolution (e.g., beam width), which can also improve imaging (Zero-loss TEM) and spatial resolution of microanalytical techniques (EELS-mapping).

FIGs. 6A-6C are data plots illustrating analytical data for dispersion, Boersch effect, and normalized beam energy distribution (FWHM), respectively, for a dispersing monochromated electron source configured for use in a transmission electron microscope (TEM) system, in accordance with embodiments of the present disclosure. The following two sections describe a mathematical treatment of the influence of an excitation parameter ("$\phi$") on the magnitude of the Boersch effect in energy-dispersive monochromators, and derives relationships between excitation parameters and the performance of the monochromators in TEM systems. To that end, although discussion of various mathematical expressions and physical phenomena is provided, embodiments of the present disclosure are not bound to a specific physical mechanism of action or a specific mathematical formulation. Section 1, below, describes an example embodiment of a double-focusing Wien Filter, discussed in more detail in reference to FIGs. 2-5, above. Section 2 describes a general case for an energy-dispersive optic, extending the treatment of Section 1 to systems and techniques other than the double-focusing Wien filter.

## 1. DOUBLE FOCUSING WIEN FILTER

In a first example, a charged particle beam primarily includes electrons. In this example, the following expressions and identities apply:

$\eta = (e/(2m))^{1/2}$, in which e is the fundamental electron charge and m is the electron mass;

a straight optical axis identified as the "z"-axis in cartesian or cylindrical space; and

an expression for a beam voltage in a Wien filter $= U + \Delta U = U(1+\kappa)$ with $\kappa = \Delta U/U$, where $U$ = nominal beam voltage below the electron source (e.g., U is defined as the potential at the electron source, such that the energy of an electron is $eU$ or $e(U_o + dU)$ for a source with a nominal energy $U_o$ and an energy spread, dU).

Typically U is less than about 10 kV, so a non-relativistic approximation is appropriate, as is the SCOFF approximation (assuming an entrance angle of the beam that is normal to the magnetic field B, such that the quadrupole field is zero). The combined effect of the approximations includes that fringe fields at the entrance and exit of the Wien filter can be neglected.

The magnetic dipole field $B_y$ can be represented by the vector potential $\vec{A} = (0,\, 0,\, -x \cdot B_y)$. Next to the dipole field $E_x = 2\eta B_y U^{1/2}$, which can counteract the magnetic dipole field for nominal energy, a quadrupole potential $\phi_2 = a_2(x^2 - y^2)$ can be applied. The Wien filter can be made double focusing by setting $a_2 = E_x^2/(8U)$. A simplified model for the electron-electron interactions includes that each electron experiences a constant electric field $E_{z,B}$ caused by its neighbors (different for each electron) during traversal through the Wien filter. An evolution parameter, "z," is used in the model.

The Hamiltonian H(x, y, p, q, z) for the SCOFF Wien filter is given by

$$H = \eta A_z - (\varphi(x,\, y,\, z) - p^2 - q^2)^{1/2}\,, \qquad (2.1)$$

in which $A_z = -x B_y$ and

$$\varphi(x,\, y,\, z) = U(1 + \kappa) - E_x\, x + a_2(x^2 - y^2) - E_{z,B}\, z\,. \qquad (2.2)$$

The evolution parameter is selected such that z = 0 at the slit plane, making the electron energy independent of $E_{z,B}$ at the slit plane. It can be assumed that the Wien filter runs from z = -L to z = 0, and that there is a beam crossover and an energy selecting slit at z = 0.

In the filter entrance plane z = -L, the electron energy is equal to $e[U(1 + \kappa) + E_{z,B}L]$. Electrons that travel with identical energy through the slit, having experienced different values of $E_{z,B}$, can enter the filter with a distribution of energies. The variation in these entrance energies can be relatively smaller than the energy spread of the source of electrons with which the beam is generated.

The Hamilton equations are

$$x' = \partial H/\partial p,\ p' = -\partial H/\partial x\,,\ y' = \partial H/\partial q\,,\ q' = -\partial H/\partial y\,. \qquad (2.3)$$

For the relevant fundamental rays the Hamiltonian can be truncated to

$$H = \frac{1}{2\sqrt{U}}\left(p^2 + q^2\right) + \frac{1}{2}\sqrt{U}K^2(x^2 + y^2) + \sqrt{U}\,\frac{K \cdot x}{\sqrt{2}}\left(-\kappa + \frac{E_{z,B} \cdot z}{U}\right),\ (2.4)$$

for which an excitation parameter $K = E_x/(\sqrt{8U})$, with unit of inverse meters (m$^{-1}$). Considering a subset of fundamental rays (e.g. excluding field rays), the rays x(z), y(z) can be described by mathematical expressions:

$$x(z) = \alpha \cdot x_\alpha(z) + \kappa \cdot x_\kappa(z) + E_{z,B} \cdot x_B(z) \qquad (2.5)$$

$$y(z) = \beta \cdot y_\beta(z) \qquad (2.6)$$

featuring the ray parameters $\alpha$, $\beta$, $\kappa$ and $E_{z,B}$ Here a new fundamental ray $x_B(z)$ for the Boersch effect is introduced, in the approximation of constant Coulomb force $E_{z,B}$ (different for each electron) on an electron by its neighbors. The Boersch effect is maximally reduced if $x_B(z) = 0$ in the energy selection plane. The axial rays follow the expressions

$$x'_\alpha(0) = y'_\beta(0) = 1$$

, such that $\alpha$, $\beta$ are image side angles in the plane z = 0.

The fundamental ray $x_B(z)$ can be introduced as approximating the Boersch effect. The Hamilton equations lead to the equation of motion:

$$X' = AX + B(z), \text{ with } A = \begin{pmatrix} 0 & \frac{1}{\sqrt{U}} \\ -K^2\sqrt{U} & 0 \end{pmatrix} \quad (2.7)$$

$$B(z) = \begin{pmatrix} 0 \\ K\frac{\sqrt{U}}{\sqrt{2}} \left( \kappa - \frac{E_{z,B}}{U} z \right) \end{pmatrix}. \quad (2.8)$$

This is a linear inhomogeneous differential equation, which can be solved using the 'variation of constants' method. It follows that

$$x_\alpha(z) = K^{-1}\sin(Kz) \text{ and } y_\beta(z) = K^{-1}\sin(Kz) \quad (2.9)$$

and for the central ray, starting with x(-L) = x'(-L) = 0, the x-position in the slit plane can be given by

$$x_{\text{slit}} = -\frac{1}{\sqrt{2}} \int_{-L}^{0} dz \, Kx_\alpha(z) \left( \kappa - \frac{E_{z,B}}{U} z \right)$$

$$= -\frac{1}{\sqrt{2}} \int_{-L}^{0} dz \, \sin(Kz) \left( \kappa - \frac{E_{z,B}}{U} z \right) \quad (2.10)$$

Hence, the dispersion, "D" follows from

$$x_{\text{slit},1} = -\frac{1}{\sqrt{2}} \int_{-L}^{0} dz \, \sin(Kz) = \frac{\kappa L}{\sqrt{2}} \frac{(1 - \cos\phi)}{\phi} \quad (2.11)$$

namely

$$D = \frac{x_{slit,1}}{\Delta U} = \frac{L}{\sqrt{2} U} \frac{(1 - \cos\phi)}{\phi}, \quad (2.12)$$

in which the Wien filter excitation parameter $\phi$ can be defined as $\phi$ = KL, and the approximate Boersch effect scales with

$$x_{\text{slit},2} = \frac{E_{z,B}}{\sqrt{2} U} \int_{-L}^{0} dz \, z \, \sin(Kz) = \frac{E_{z,B} L^2}{\sqrt{2} U} \frac{(\sin\phi - \phi\cos\phi)}{\phi^2}. \quad (2.13)$$

where $x_{\text{slit}} = x_{\text{slit},1} + x_{\text{slit},2}$

FIGs. 6A-6C illustrate the variation of dispersion and Boersch effect as a function of the excitation parameter $\phi$, as described in equations 2.12 and 2.13. In the derivation above, the Boersch effect is about zero for a value of about $\phi$ = 4.5, and dispersion is relatively small (e.g., about 30% of the peak value of dispersion at about $\phi$ = 2.3).

The Wien filter axial coma $B_2$ is described by the mathematical expression:

$$B_2 = -\frac{L}{\sqrt{2}} \frac{(1 - \cos\phi)}{\phi} = -DU \quad (2.14)$$

From which it is found that axial coma scales with dispersion. Where beam aberrations influence the energy resolution of the monochromator. The data for FIGs. 6A-6C correspond to values of U = 1 kV, Wien filter length L = 50 mm, current above slit = 10 nA, reduced brightness $\beta_r = 5 \cdot 10^7$ A/(V·m$^2$·sr), and an assumed optimal opening angle and optimal slit width.

The size of the probe in the slit plane was approximated with a simple root-sum-square method. The full-width at half maximum of the energy distribution (FWHM) and the shape of the long tails (heavily influenced by the Boersch effect) contribute significantly to the energy distribution of the beam below the slit (e.g., about 0.1 % of maximum). To that end, a value of $\phi$ smaller than the value for which the approximate Boersch effect is zero (e.g. $\phi = 4$ instead of $\phi = 4.5$) improves the performance of the monochromator in terms of Boersch effect and dispersion. Note that the values and curves described are prepared under an assumption of slit position at z = 0 and that fringe fields are neglected. As such, the performance of the monochromator will differ in simulations based on different assumptions, such as where fringe fields are included and/or the selection slit is moved.

## 2. GENERAL CASE OF A DISPERSIVE OPTIC

To that end, the Wien filter can be generalized to a case where fringe fields are included and/or the slit plane is in a different position and/or there is a line-focus in the slit instead of a point-focus. The monochromator can also be generalized to devices with a curved optical axis, because dispersion can also be created by magnetic and/or electrostatic prisms. In that case, the optical axis can be defined as the central ray of nominal energy. The distance coordinate along the central ray is defined as "z," and "x, y" are the corresponding orthogonal curvilinear coordinates. If the optical axis lies in the x-z plane, the non-relativistic Hamiltonian H(x, y, p, q, z) is given by the mathematical expression:

$$\mathcal{H} = (1 - \Gamma_x(z)x) \cdot \left[ \eta A_z - \left( \varphi + \Delta U + \varphi_B - (p + \eta A_x)^2 - (q + \eta A_y)^2 \right)^{\frac{1}{2}} \right] (3.1)$$

where the Boersch potential $\varphi_B = \varphi_B(z)$ is further described below, and $\Gamma_x(z)$ is the curvature (e.g., $\Gamma_x(z)$ = zero for a straight optical axis). Along a circle segment in the x-z plane, $\Gamma_x$ = 1/(circle radius). The potential $\varphi$ and the magnetic vector potential $\vec{A}$ are both functions in cartesian space (e.g., in an (x, y, z) orthogonal coordinate system), and the axial potential U(z) is defined as $\varphi(0, 0, z)$.

The main dispersion can be generated and magnified in the xz-plane. Incorporating the Boersch effect, a relativistic treatment adds significant complexity to analytical descriptions of dispersion. For at least this reason, the non-relativistic approximation is maintained in the general case, also for monochromators at ground potential. Suppression of the Boersch effect is relevant for vibrational EELS, which is typically performed at beam energies less than or equal to about 80 kV, making the non-relativistic approximation appropriate. As before z = 0 in the slit plane. It should be noted that, for the Wien filter treated in section 2, an optical designer would typically dismiss a value of $\phi$ larger than $\pi$, at least because the dispersion equation 2.10, above, would give the integrand sin(Kz) = sin($\phi$z/L) being negative for some values of z. A negative value of dispersion would indicate that dispersion is compromised, seemingly without any benefit to the performance of a monochromator.

In most cases, the beam energy is stable (e.g., constant) in the region where the Boersch effect is to be calculated, in which case the expression $\varphi B = -E_{z,B}z$ can be used. An exception to this approximation occurs in systems where an accelerator is disposed between a monochromator and an energy selecting slit. Acceleration results in an increase of average distance between charged particles, which implies that the Boersch potential generalizes to

$$\varphi_B(z) = -E_{z,B}(z) z \ with \ E_{z,B}(z) = \frac{E_{z,B,start} U_{start}}{U(z)} (3.2)$$

In the following description, it is assumed that the beam energy from monochromator entrance plane to slit-plane is constant, however U(z)$^3$ can be variable. The matrix A can be generalized into A(z), but in general (also including fringe fields) an analytical expression for x$\alpha$(z) and y$\beta$(z) is more complex and is unavailable in some situations. Combining equations, using a non-relativistic approximation, and applying z = $z_{slit}$ and $x_\alpha = x_\alpha$(zslit), results in the expression:

$$\text{xslit} \propto \int_{z_{start}}^{0} dz \, \kappa \, \psi_{1s}(z) x_\alpha(z) \, , (3.3)$$

in which $z_{start} < 0$. The equation for the dispersion in a dispersive device can be developed where $\psi_{1s}(z)$ is a dispersion generating function which is nonzero inside dipole Wien filters and/or prisms, and which can have either sign. The general Hamiltonian (3.1) shows that the addition of Boersch effect term involves the replacement of $\kappa$ by $\kappa$ - ($E_{z,B}$/U)z, as in the previous section. And again as in the previous section, the 'variation of constants' method can be employed, by which equation 3.3 generalizes to

$$\text{xslit} \propto \int_{z_{start}}^{0} dz \left(\kappa - \frac{E_{z,B}}{U} z\right) \psi_{1s}(z) x_{\alpha}(z) \ , (3.4)$$

$$\text{dispersion} \propto \int_{z_{start}}^{0} dz \, \psi_{1s}(z) x_{\alpha}(z) \ (3.5)$$

and

$$\text{approximate Boersch effect} \propto \int_{z_{start}}^{0} dz \, z \, \psi_{1s}(z) x_{\alpha}(z) \ . (3.6)$$

Typical designs for monochromators maximize the dispersion, as an approach to optimize the FWHM of the energy distribution. In this way, in a design with a number of prisms, as in a curved axis-type monochromator (e.g., alpha-type, omega-type, etc.), the sign of $\int_{one \, prism} dz \, \psi_{1s}(z) x_{\alpha}(z)$ can be the same for all prisms. Equation 3.6 (with $z < 0$ for the entire integrand) shows that the approximate Boersch effect can be substantially zero or negligible for monochromators with multiple prisms, as in a curved axis monochromator, that applies the techniques of the present disclosure.

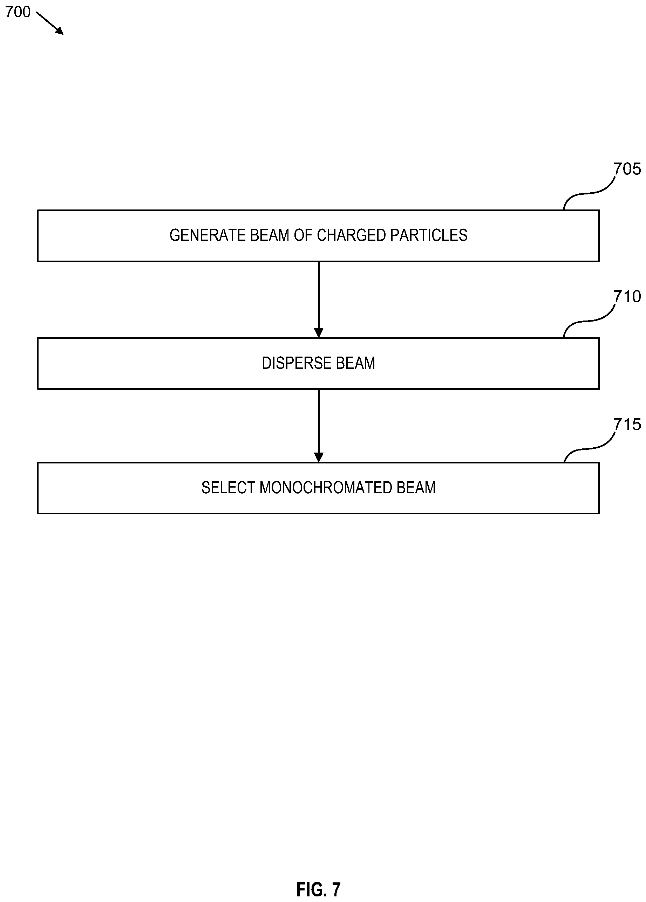

FIG. 7 is a block flow diagram of an example process 700 for generating a monochromated beam of charged particles, in accordance with some embodiments of the present disclosure. As described in reference to FIGS. 1-6C, one or more operations making up the example process 500 can be executed by a computer system operably coupled with components of a charged particle microscope (e.g., TEM system 100 of FIG. 1) and/or additional systems or subsystems including, but not limited to, characterization systems, network infrastructure, databases, and user interface devices. To that end, operations can be stored as machine executable instructions in one or more machine readable media.

Operations of the example process 700 can be repeated, reordered, and/or omitted, for example, as part of performing a vibrational EELS workflow. To that end, the operations of example process 700 are described as being performed by a system, where it is understood that the operations can include generating and communicating control signals between a processor or other logic circuit and electronic or electromechanical elements of the charged particle microscope. The operations of example process 700 are described in the context of an electron microscope in the interest of clarity. Embodiments of the present disclosure include processes for generating monochromated ion beams, as well as other charged particle configurations, such as dual beam systems.

Example process 700 includes generating a beam of charged particles at operation 705. The beam of electrons 310 of FIG. 3 is an example of the beam of charged particles of operation 705. Generating the beam of charged particles can include energizing an emitter source (e.g., source 305 of FIG. 3) by modulating a high voltage supply coupled with the emitter source. As would be understood by a person of ordinary skill in the art, operation 705 can be preceded by one or more operations and/or sub-operations, such as evacuating the environment surrounding the source down a high vacuum or ultrahigh vacuum or completing an internal calibration test, cleaning cycle, or other processes that form part of the operation of charged particle microscopy systems. To that end, in some embodiments of example process 700, for example, where an electron microscope switches from one operative mode (e.g., TEM imaging mode) to another (e.g., spot-mode EELS), generating the beam of charged particles can refer to modifying the operation of the source (e.g., via one or more control instructions executed by the computer system) to facilitate microanalysis, such as vibrational EELS.

Example process 700 includes dispersing the charged particles of the beam of charged particles at operation 710. As described in more detail in reference to FIGs. 2-5, energy-dispersal of charged particles (e.g., electrons 310 of FIG. 3) can be effected by modifying one or more parameters of a dispersing element (e.g., dispersing element 315 of FIG. 3), which can include an electric field in a Wien filter, a magnetic field of the Wien filter, and/or one or more parameters of an accelerator (e.g., including multiple annular electrodes mutually separated by a dielectric). To that end, monochromators can be included as part of charged particle optical devices (e.g., electron optical device 115 of FIG. 1) to selectively filter, block, or otherwise remove regions of the energy distribution from the charged particles emitted from the source (e.g., using the dispersive element 315 and selector 320 of FIG. 3). Advantageously, operation 710 can attenuate, reduce, or otherwise substantially eliminate the influence of the Boersch effect on energy distributions, as described in more detail in reference to FIGs. 5-6C and illustrated in comparative data of FIGs. 8A-9B. In some embodiments, the operation of the dispersing element, characterized by an excitation parameter, $\phi$, that has a value from about $0.5\pi$ to about $1.5\pi$, including subranges, fractions, and interpolations thereof (e.g., about $0.75\pi$). In an example, the excitation parameter can be about 4.3.

Example process 700 includes narrowing the energy distribution of the beam at operation 715, as part of generating a monochromated beam of charged particles. In some embodiments, narrowing the energy distribution includes selectively blocking, redirecting, absorbing, or otherwise attenuating charged particles using a selector (e.g.,

selector 320 of FIG. 3) being disposed on or about a beam axis (e.g., beam axis A). As described in more detail in reference to FIG. 3 and FIG. 5, the selector can be substantially co-located with a third crossover of the beam of charged particles, such that the beam, being dispersed in a plane substantially normal to the axis, includes charged particles having a range of energies in accordance with a spatial distribution relative to the beam axis (e.g., as illustrated in reference to FIG. 2). To that end, the selector can remove from the beam those charged particles having energies outside a tolerable deviation from a target energy, U, such that a monochromated beam exits the source with an improved energy distribution relative to techniques of the current art, for which the influence of the Boersch effect broadens the energy distribution at the selector.

FIGs. 8A-10B illustrate a series of comparative examples developed for the charged particle optical devices of FIGs. 2-5. The data presented were generated by simulating the constituent components of the devices using Monte Carlo (e.g., stochastic) simulation methods that include physical models for coulombic interaction and Boersch effect. The examples presented are demonstrative of a monochromated electron source configured to operate at different values of the excitation parameter, "$\phi$." As such, the simulations describe a source configured to generate a monochromated beam of electrons characterized by a FWHM of about 5 meV to about 30 meV and a beam current of about 10 pA to about 200 pA. FIGs. 8A-8B correspond to a source operating in accordance with typical parameters ($\phi \approx \pi/2$), as in the current art and as described in reference to FIG. 2 and FIG. 4. FIGs. 9A-9B correspond to a source operating in accordance with embodiments of the present disclosure, as described in reference to FIG. 3 and FIG. 5. The graphs plot normalized intensity vs. differential energy, described relative to a target energy U, which can be understood to correspond to a beam energy from about 1 kV to about 500 kV.

FIGs. 8A-8B are example energy distribution graph simulated for the electron source of FIG. 2, in accordance with the current art. The data for FIGs. 8A-8B were generated using an excitation parameter, $\phi$, value of about $\pi/2$, a beam energy in the Wien filter of about 500 V, and a beam current in the Wien filter of about 20 nA. The FWHM of the energy distribution was determined to be about 18 meV for a monochromated probe current of 56 pA, the half width at 1/10 of the maximum was determined to be about 106 meV. FIG. 8B illustrates the same data on a logarithmic scale and shows that the energy distribution half width 805 at 1/100 810 of the maximum value at about 250 meV, which is a wide enough value to overlap the range of differential energy that provides meaningful information for vibrational EELS.

FIGs. 9A-9B are example energy distribution graphs simulated for the electron source of FIG. 3, in accordance with embodiments of the current disclosure. The data for FIGs. 9A-9B were generated using an excitation parameter, $\phi$, value of about 4.3. The FWHM of the energy distribution was determined to be about 15 meV for a monochromated probe current of 84 pA, the half width at 1/10 of the maximum was determined to be about 43 meV, corresponding to an improvement of about 60%. FIG. 9B illustrates the same data on a logarithmic scale and shows that the energy distribution half width 905 at 1/100 810 of the maximum value at about 130 meV, which is a narrow enough value to distinguish the beam energy from the range of differential energy that provides meaningful information for vibrational EELS. Advantageously, the parameters used to simulate the data in FIGs. 9A-9B demonstrate that a beam of higher current (e.g., about 1.5X) can exhibit improved energy resolution by about 40%-60% based at least in part on reducing the influence of the Boersch effect in a monochromated source.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on charged particle source components and systems, and transmission electron microscopy electron source systems in particular, these are meant as non-limiting, illustrative embodiments. Embodiments of the present disclosure are not limited to such systems, but rather are intended to address analytical instruments systems for which a wide array of material samples can be analyzed to determine chemical, biological, physical, structural, or other properties, among other aspects, including but not limited to chemical structure, trace element composition, or the like, using a monochromated beam of charged particles to generate detectable signals via interaction of the beam with the samples.

Some embodiments of the present disclosure include a system including one or more data processors and/or logic circuits. In some embodiments, the system includes a non-transitory computer readable storage medium containing instructions which, when executed on the one or more data processors and/or logic circuits, cause the one or more data processors and/or logic circuits to perform part or all of one or more methods and/or part or all of one or more processes and workflows disclosed herein. Some embodiments of the present disclosure include a computer-program product tangibly embodied in non-transitory machine-readable storage media, including instructions configured to cause one or more data processors and/or logic circuits to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property within which the deviation has little to no influence of the corresponding function, property, or attribute of the structure being described. In an illustrated example, where a dimensional parameter is described as "substantially equal" to another dimensional parameter, the term "substantially" is intended to reflect that the two parameters being compared can be unequal within a tolerable limit, such as a fabrication tolerance or a confidence interval inherent to the operation of the system. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. For numerical values, such as diameters, lengths, widths, or the like, the term "about" can be understood to describe a deviation from the stated value of up to ±10%. For example, a dimension of "about 10 mm" can describe a dimension from 9 mm to 11 mm.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims. Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

**Claims**

1. A charged particle optical device, comprising:

    a Wien filter disposed on a beam axis, the Wien filter being configured to disperse particles of a beam of charged particles by energy in a dispersion plane parallel with the beam axis;
    an optical element disposed on the beam axis downstream of the Wien filter and configured to focus the beam of charged particles toward the beam axis; and
    a selector, disposed on the beam axis at a position substantially corresponding to a third crossover plane downstream of the optical element.

2. The charged particle optical device of claim 1, wherein the beam of charged particles defines a first crossover plane at a first point on the beam axis within the Wien filter, and a second crossover plane downstream of the first crossover plane at a second point on the beam axis substantially coinciding with an exit from the Wien filter.

3. The charged particle optical device of claim 1, wherein the Wien filter comprises a double-focusing Wien filter.

4. The charged particle optical device of claim 1, wherein the Wien filter is **characterized by** an excitation parameter, $\varphi$, and wherein the position corresponds to a value of the excitation parameter $\varphi$ greater than about $3\pi/4$.

5. The charged particle optical device of claim 4, wherein the position corresponds to a value of the excitation parameter $\varphi$ from about $\pi$ to about $3\pi/2$.

6. The charged particle optical device of claim 5, wherein the position corresponds to a value of the excitation parameter $\varphi$ of about 4.3.

7. The charged particle optical device of claim 1, wherein the optical element is further configured to accelerate the particles of the beam of charged particles.

8. The charged particle optical device of claim 1, wherein the beam of charged particles is **characterized by** a first beam current from about 5 nA to about 50 nA at an entrance to the Wien filter and a second beam current greater than about 60 pA below the energy selector.

9. The charged particle optical device of claim 8, wherein, downstream of the selector, the beam of charged particles is **characterized by** an energy distribution having a half-width at one hundredth of a maximum value from about 40 meV, preferably 80meV, to about 200 meV.

10. The charged particle optical device of claim 1, wherein the selector defines an aperture having a characteristic width from about 0.3 $\mu$m to about 1.3 $\mu$m.

11. A charged particle beam system, comprising:

   a charged particle source, configured to generate a beam of charged particles substantially aligned with a beam axis;
   a monochromator, comprising the Wien filter of any one of claims 1-10; and
   a condenser lens, disposed on the beam axis downstream of the monochromator and configured to focus particles of the beam of charged particles toward the beam axis.

12. The system of claim 11, further comprising input optics configured to receive the beam of charged particles from the charged particle source and to focus the beam of charged particles toward the beam axis, wherein the input optics are disposed on the beam axis between the charged particle source and the monochromator.

**FIG. 1**

**FIG. 2**

**FIG. 3**

EP 4 679 481 A1

**FIG. 4**

**FIG. 5**

FIG. 6A

FIG. 6B

FIG. 6C

700

705

| GENERATE BEAM OF CHARGED PARTICLES |
| --- |

710

| DISPERSE BEAM |
| --- |

715

| SELECT MONOCHROMATED BEAM |
| --- |

**FIG. 7**

dU (FWHM) = 18 meV
dU (FWM/10) = 106 meV
I (mono) = 56 pA

**FIG. 8A**

250 meV

805

810

**FIG. 8B**

dU (FWHM) = 15 meV
dU (FWM/9) = 43 meV
I (mono) = 84 pA

FIG. 9A

FIG. 9B

Europäisches
Patentamt

European
Patent Office

Office européen
des brevets

# EUROPEAN SEARCH REPORT

**Application Number**

EP 25 18 1941

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2016 126914 A (APCO:KK; NAT INST FOR MATERIALS SCIENCE) 11 July 2016 (2016-07-11) * figs. 1 to 4, 9 to 11 and related text; paragraph [0006] * * abstract * ----- | 1,3,7-12 | INV. H01J37/05 H01J37/26 |
| X | US 2024/087863 A1 (WEHRS HENNING [DE] ET AL) 14 March 2024 (2024-03-14) * figs. 2 and related text; paragraphs [0079], [0134] - [0138] * ----- | 1,8-12 | |
| X | US 2010/096550 A1 (YAMAZAKI YUICHIRO [JP] ET AL) 22 April 2010 (2010-04-22) * fig. 66 and related text; paragraphs [0679] - [0681] * ----- | 1-6,8-12 | |
| X | JP 2007 149495 A (JEOL LTD) 14 June 2007 (2007-06-14) * figs. 17, 31 and related text; paragraphs [0056], [0119] * ----- | 1-6,8-12 | TECHNICAL FIELDS SEARCHED (IPC) |
| A | Frank Kahl: "Design eines Monochromators für Elektronenquellen", , 1 January 1999 (1999-01-01), XP055011065, Darmstadt Retrieved from the Internet: URL:http://tuprints.ulb.tu-darmstadt.de/epda/000030/diss_kahl.pdf [retrieved on 2011-11-03] * page 28 * ----- -/-- | 8 | H01J |

The present search report has been drawn up for all claims

| Place of search | Date of completion of the search | Examiner |
|---|---|---|
| Munich | 27 November 2025 | Krauss, Jan |

EPO FORM 1503 03.82 (P04C01)

Europäisches
Patentamt

European
Patent Office

Office européen
des brevets

## EUROPEAN SEARCH REPORT

**Application Number**

EP 25 18 1941

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | UHLEMANN S ET AL: "Experimental Set-Up of a fully electrostatic Monochromator for a 200 kV TEM", PROCEEDINGS OF THE INTERNATIONAL CONGRESS ON ELECTRONMICROSCOPY. ICEM, XX, XX, no. 15th, 1 September 2002 (2002-09-01), pages 327-328, XP009089837, * page 327, paragraph 2 * | 10 | |
| A | DAVID C BELL ET AL: "Sub-Ångstrom Low-Voltage Performance of a Monochromated, Aberration-Corrected Transmission Electron Microscope", MICROSCOPY AND MICROANALYSIS, JONES AND BEGELL PUB, vol. 16, no. 4, 1 August 2010 (2010-08-01), pages 386-392, XP001555646, ISSN: 1431-9276, DOI: 10.1017/S1431927610093670 [retrieved on 2010-07-02] * figure 4 * | 10 | |
| X,P | DE 10 2024 101365 A1 (FEI CO [US]) 25 July 2024 (2024-07-25) * the whole document * * figs. 1, 3A, 4, 5 and related text * | 1-6,8,9, 11,12 | **TECHNICAL FIELDS SEARCHED (IPC)** |

The present search report has been drawn up for all claims

| Place of search | Date of completion of the search | Examiner |
|---|---|---|
| Munich | 27 November 2025 | Krauss, Jan |

EPO FORM 1503 03.82 (P04C01)

## ANNEX TO THE EUROPEAN SEARCH REPORT
## ON EUROPEAN PATENT APPLICATION NO.

EP 25 18 1941

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2025

| Patent document cited in search report | Publication date | Patent family member(s) | Publication date |
|---|---|---|---|
| JP 2016126914 A | 11-07-2016 | JP 6432905 B2<br>JP 2016126914 A | 05-12-2018<br>11-07-2016 |
| US 2024087863 A1 | 14-03-2024 | CN 117711908 A<br>EP 4339995 A1<br>GB 2622401 A<br>US 2024087863 A1 | 15-03-2024<br>20-03-2024<br>20-03-2024<br>14-03-2024 |
| US 2010096550 A1 | 22-04-2010 | TW 200703409 A<br>TW 200939283 A<br>US 2009212213 A1<br>US 2010096550 A1<br>WO 2006093268 A1 | 16-01-2007<br>16-09-2009<br>27-08-2009<br>22-04-2010<br>08-09-2006 |
| JP 2007149495 A | 14-06-2007 | NONE | |
| DE 102024101365 A1 | 25-07-2024 | CN 118380303 A<br>DE 102024101365 A1<br>JP 2024103470 A<br>US 2024249905 A1 | 23-07-2024<br>25-07-2024<br>01-08-2024<br>25-07-2024 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 76748524